Europäisches Patentamt

European Patent Office

Office européen des brevets

(11) Publication number: **0 394 054**
**A1**

# EUROPEAN PATENT APPLICATION

(21) Application number: **90304236.4**

(22) Date of filing: **20.04.90**

(51) Int. Cl.5: **H01L 21/38, C23C 16/34, C23C 16/44**

(30) Priority: **21.04.89 JP 102416/89**

(43) Date of publication of application:
**24.10.90 Bulletin 90/43**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Gomi, Hideki, c/o NEC Corporation**
**7-1 Shiba 5-chome, Minato-ku**
**Tokyo 108-01(JP)**

(74) Representative: **Abnett, Richard Charles et al**
**REDDIE & GROSE 16 Theobalds Road**
**London WC1X 8PL(GB)**

(54) Method of manufacturing siliconboron nitride film having excellent step coverage characteristic.

(57) A silicon-boron nitride film is formed over wirings on a semiconductor substrate, by a chemical vapor deposition method using at least an organosilicon compound, an organoboron compound and ammonia or an organic compound containing nitrogen as the raw material gases. Hexamethylcyclotrisilazane [-$(CH_3)_2SiNH]_3$ or hexamethyldisilazane [$Si(CH_3)_3]_2$ is preferred as the organosilicon compound, and trimethylboron $B(CH_3)_3$ or triethylboron $B(C_2H_5)_5$ is preferred as the organoboron compound.

Fig. 2(b)

## METHOD OF MANUFACTURING SILICON-BORON NITRIDE FILM HAVING EXCELLENT STEP COVERAGE CHARACTERISTIC

### BACKGROUND OF THE INVENTION

#### Field of the Invention

The present invention relates to a method of manufacturing a silicon-boron nitride film, and more particularly to a method of manufacturing a silicon-boron nitride film to be used for semiconductor devices.

#### Description of the Related Art

Conventionally, a silicon-boron nitride ($Si_xB_yN_z$, $x + y + z = 1$ : SiBN) film used to cover the wirings of a semiconductor device is formed by a chemical vapor deposition method using silane ($SiH_4$), diborane ($B_2H_6$) and ammonia ($NH_3$) as the raw material gases, as disclosed in Japanese Patent Laid Open No. 62-156822.

However, when a film is deposited by using the aforementioned gas system, the film formed is of overhanging type which is thick on the wirings and thin between the wirings and on the sidewalls of the wirings. Moreover, diborane and ammonia are highly reactive so that when the partial pressure of diborane is increased in order to raise the boron concentration in the film, there breaks out a vapor phase reaction which aggravates the step coverage characteristic.

When a SiBN film thus formed is used as the interlayer film between the wirings, there can occur disconnections or a short-circuiting in the upper wirings.

In addition, there occurs another problem in that a large number of particles are generated within the vapor deposition apparatus due to the vapor phase reaction between diborance and ammonia.

### SUMMARY OF THE INVENTION

Accordingly, it is an object of the present invention to provide a method of manufacturing a silicon-boron nitride film having an excellent step coverage characteristic.

It is another object of the present invention to provide a method of manufacturing a silicon-boron nitride film which can reduce the number of particles generated within the vapor deposition apparatus.

The method of manufacturing a silicon-boron nitride film in accordance with the present invention includes a step of manufacturing a silicon-boron nitride film by a chemical vapor deposition method which uses a raw material gas including an organosilicon compound, an organoboron compound and a compound containing nitrogen.

An organosilicon compound and an organoboron compound are less tended to initiate decomposition or reaction suppressing vapor phase reactions so that the surface reactions become dominant. Therefore, it becomes possible to form a silicon-boron nitride film having excellent step coverage characteristic by the present invention. Further, the vapor reaction during the chemical vapor deposition can be suppressed so that the number of particles generated within the vapor deposition apparatus can be reduced, which enhances the yield of the semiconductor devices.

As the compound containing nitrogen, it is preferable to use ammonia or an organic compounds containing nitrogen. As an organic compounds containing nitrogen, it is preferable to use triethylamine $N(C_2H_5)_3$.

As the organosilicon compound, it is preferable to use hexamethylcyclotrisilazane $[(CH_3)_2SiNH]_3$ or hexamethyldisilazene $[Si(CH_3)_3]_2NH$.

As the organoboron compound, it is preferable to use trimethylboron $B(CH_3)_3$ or triethylboron $B(C_2H_5)_3$

As the carrier gas for carrying these raw material gasses, it is preferable to use $H_2$, $N_2$, He or Ar.

As the chemical vapor deposition method, use may be made of a plasma chemical vapor deposition method or a photo-assisted chemical vapor deposition method. Further, a silicon-boron nitride film may be formed by a chemical vapor deposition method in which a compound containing nitrogen such as ammonia is decomposed in advance using an ultraviolet radiation or plasma, then by mixing other raw material gases to it.

### BRIEF DESCRIPTION OF THE DRAWINGS

The above and further objects, features and advantages of the present invention will become more apparent from the following detailed description taken in conjunction with the accompanying drawings, wherein:

Fig. 1 is a block diagram for the plasma chemical vapor deposition apparatus used for a first embodiment of the present invention;

Figs. 2(a) and 2(b) are sectional diagrams of a semiconductor chip shown in the order of the steps for explaining the first embodiment of the present invention;

Fig. 3 is a block diagram for the photo-assisted chemical vapor deposition apparatus used for a second embodiment of the present invention; and

Fig. 4 is a block diagram for the heat-assisted chemical vapor deposition apparatus used for a third embodiment of the present invention.

DESCRIPTION OF THE PREFERRED EMBODIMENTS

(First Embodiment)

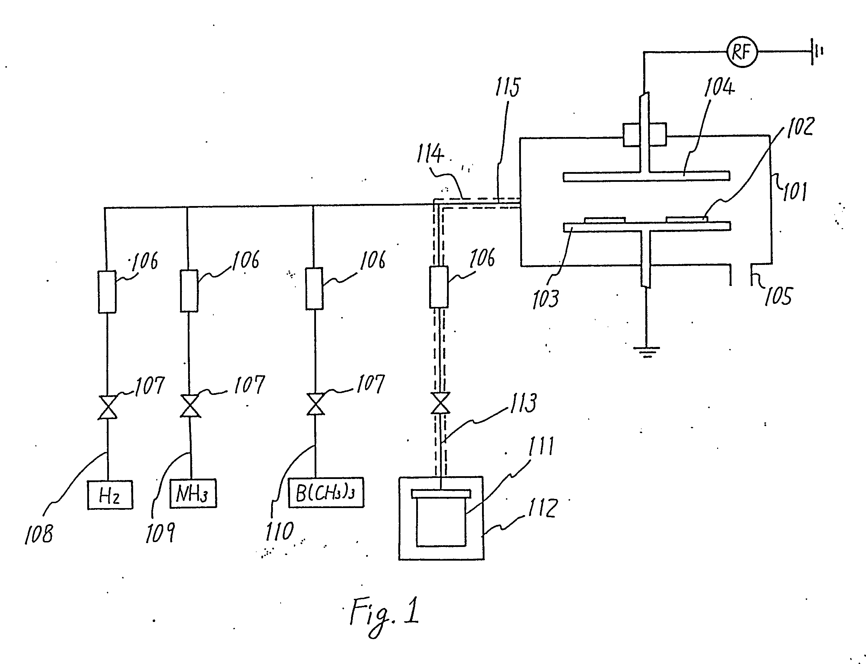

Fig. 1 is a block diagram the plasma chemical vapor deposition system used for the first embodiment of the present invention. Reference numeral 101 is a reaction chamber, 102 is a sample, 103 is an anode electrode for placing the sample 102 and 104 is a heater served also as a cathode electrode for applying a high frequency. The frequency of the high frequency power applied was 13.56 MHz. In addition, 106 is a flowmeter and 107 is a valve.

Hydrogen ($H_2$) gas and ammonia ($NH_3$) gas are introduced from a hydrogen gas supply pipe 108 and an ammonia gas supply pipe 109, respectively. Trimethylboron $B(CH_3)_3$ which is an organoboron compound is introduced from a trimethylboron supply pipe 110.

Further, hexamethylcyclotrisilazane (HMCTMSZN) $[(CH_3)_2SiNH]_3$ is supplied from a HMCTSZN container 111, which is kept at 39°C in a thermostatic chamber 112. The vapor of HMCTSZN is introduced from an HMCTSZN supply pipe 113, and after mixed with hydrogen gas, ammonia gas and trimethylboron gas, it is introduced to the interior of the reaction chamber 101 through a reaction gas introducing pipe 115. Reference numeral 114 is a heater for heating the pipeline, playing the role of preventing the precipitation of the liquid HMCTSZN material on the inside of the pipeline.

A glow discharge is generated between the cathode electrode 104 and the anode electrode 103 by applying a high frequency to the cathode electrode 104, which enables one to form an SiBN film on the sample 102 by decomposing the raw material gases.

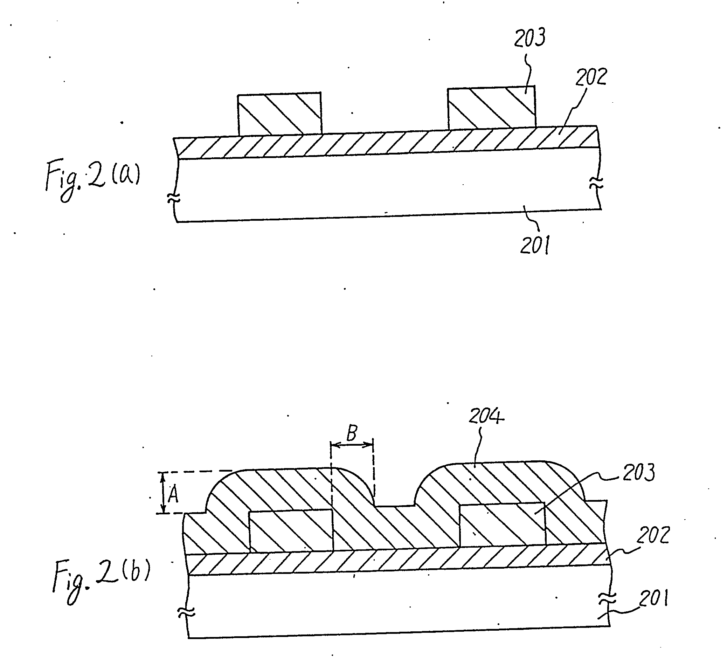

Figs. 2(a) and 2(b) are sectional diagrams of a semiconductor chip arranged in the order of steps for explaining the first embodiment of the present invention.

As shown in Fig. 2(a), first, an insulating film 202 is deposited on top of a silicon substrate 201 on which is formed a semiconductor element, then aluminum wirings 203 are formed by means of an etching method.

Next, as shown in Fig. 2(b), an SiBN film 204 with thickness of 1 $\mu$m is formed on top of the aluminum wirings 203 using the plasma vapor deposition system explained in Fig. 1. The film deposition is performed at the substrate temperature of 300°C by generating a discharge with power density of 0.5 $W/cm^2$, after setting the total gas pressure at 0.3 Torr by introducing HMCTSZN at 200 sccm, ammonia gas at 200 sccm, hydrogen gas at 1000 sccm and trimethylboron gas at 600 sccm.

The relative permittivity of the SiBN film formed under the above-mentioned conditions was 3.5, which is smaller than that of the silicon oxide film. The radio B/A of the film thickness B of the side part of the aluminum wiring shown in Fig. 2(b) to the film thickness A over the wiring was 0.95, and the step coverage characteristic was excellent.

It is to be noted that the step coverage characteristic expressed in terms of the value of the ratio B/A of the prior art SiBN film formed by using silane, ammonia and diborane was 0.7. In particular, the film thickness at the bottom part between the wirings was 0.7 $\mu$m, with a large step height from the bottom part to the top of the wiring of 1.3 $\mu$m.

As in the above, in accordance with the first embodiment, an SiBN film with small relative permittivity and excellent step coverage characteristic can be obtained. Since the parasitic capacitance between the wirings can be reduced and the disconnections or short-circuiting of the wirings can be eliminated, so that it becomes possible to accomplish multilayered wiring for a high-speed semiconductor device. Moreover, there appear no particles due to the vapor phase reaction between diborane and ammonia so that the yield of semiconductor devices can be enhanced.

(Second Embodiment)

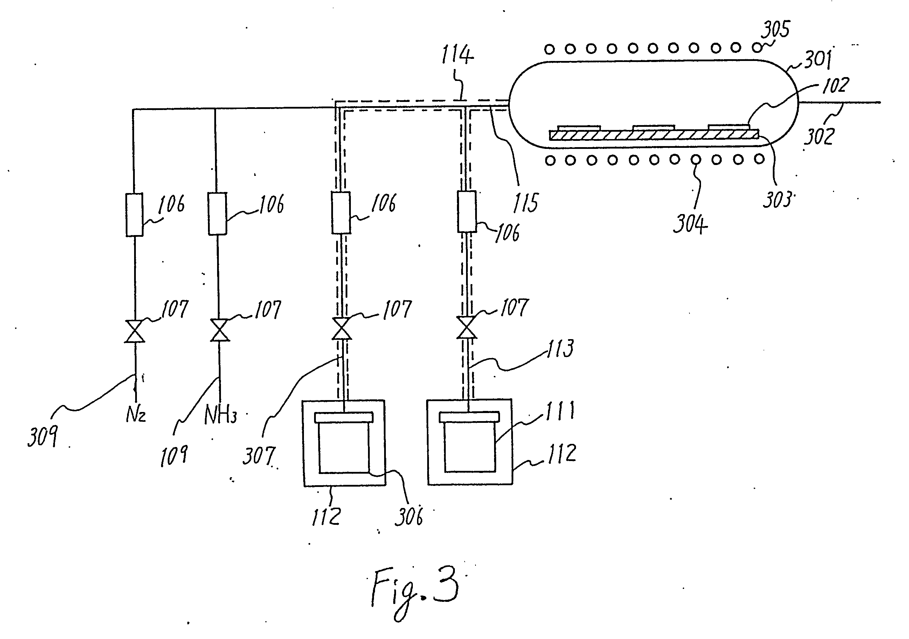

In Fig. 3 is shown a block diagram for a photo-assisted chemical vapor deposition system used for the second embodiment of the present invention.

The system is substantially the same as the vapor phase deposition system shown in Fig. 1 except for a susceptor 303 provided in a reaction oven 301 for placing a sample 102, a heater 304 for heating the sample 102 and an ultraviolet lamp 305 for decomposing the reaction gases.

Namely, nitrogen (N₂) gas and ammonia (NH₃) gas are introduced from a nitrogen gas supply pipe 309 and an ammonia gas supply pipe 109. Trimethylboron $B(C_2H_5)_3$, which is one of the organoboron compounds is placed in a triethylboron container 306 which is maintained at 70°C by a thermostatic chamber 112, and its vapor is introduced from a triethylboron supply pipe 307. The vapor of HMCTSZN is introduced from an HMCTSZN supply pipe 113. After the nitrogen gas, ammonia gas, triethylboron and HMCTSZN are mixed, the mixture is introduced to the inside of the reaction oven 301 through a reaction gas introducing pipe 115.

A SiBN film in accordance with the second embodiment of the present invention that employs a photo-assisted chemical vapor deposition system is formed by the irradiation of an ultraviolet radiation after setting the total gas pressure at 5 Torr by the introduction of HMCTSZN at 200 sccm, ammonia gas at 200 sccm, nitrogen gas at 500 sccm and triethylboron at 800 sccm. In addition, the sample temperature is set at 300°C.

The step coverage characteristic of the SiBN film formed under the conditions as mentioned above was expressed by the value of 0.9 in terms of the ratio B/A of the film thickness B of the side part of the aluminum wiring shown in Fig. 2(b) to the film thickness A over the wiring. It should be noted that in view of the step coverage rate of 0.65 for an SiBN film formed by the photo-assisted chemical vapor deposition method using silane, ammonia and diborane, the step coverage characteristic of the SiBN film obtained by the second embodiment is enhanced markedly. Further, the relative permittivity of the SiBN film formed by the second embodiment is 3.6 which is a small value similar to the case of the first embodiment.

(Third Embodiment)

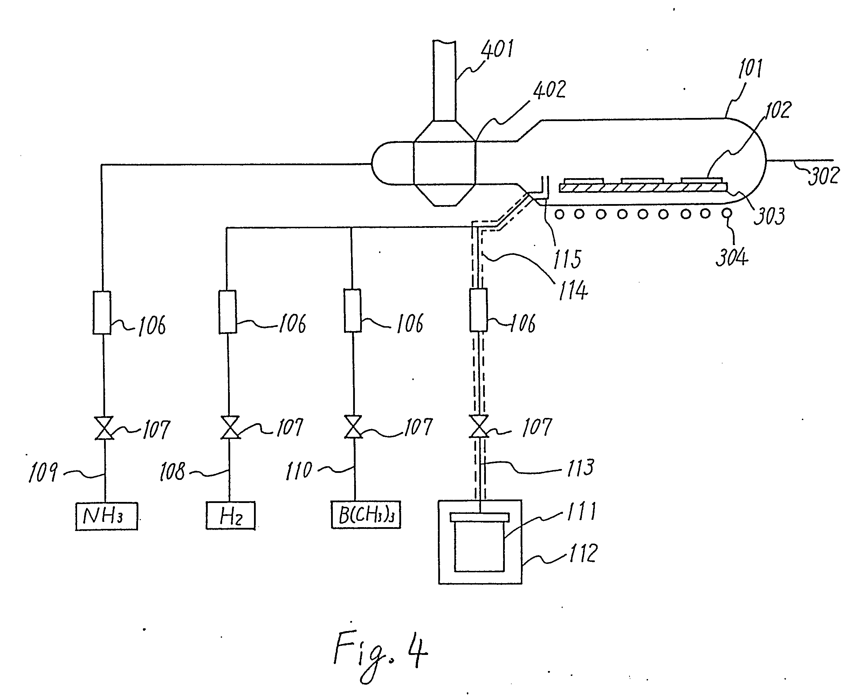

In Fig. 4 is shown a block diagram for a heat-assisted chemical vapor deposition system in which ammonia gas alone among other gases is used decomposed in advance by microwave discharge, for explaining the third embodiment of the present invention.

Within a reaction chamber 101 there are provided a susceptor 303 for placing a sample 102 and a heater 304 beneath the susceptor for heating the sample 102. Further, in front of the reaction chamber 101, there are provided a microwave introducing pipe 401 for introducing microwaves to be used for decomposing ammonia gas, and an ammonia decomposition chamber 402. Ammonia gas is introduced from an ammonia gas supply pipe 109, and is decomposed in the ammonia decomposition chamber 402. Further, hydrogen (H₂) gas and trimethylboron B(CH₃)₃ which is one of organoboron compounds are introduced from a hydrogen gas supply pipe 108 and a trimethylboron supply pipe 110, respectively. The vapor of HMCTSZN is through an HMCTSZN supply pipe 113 from an HMCTSZN container 111, which is maintained at 39°C by a thermostatic chamber 112. After the HMCTSZN vapor is mixed with hydrogen gas and trimethylboron gas, the mixed gas is introduced to the interior of the reaction chamber 101 through a reaction gas introducing pipe 115. These gases and ammonia gas decomposed in the ammonia decomposition chamber 402 are mixed within the reaction chamber 101.

The conditions for the formation of the SiBN film in accordance with the third embodiment using the system constructed as in the above are as follows. Namely, first, HMCTSZN is introduced at 200 sccm, ammonia gas is introduced at 200 sccm, nitrogen gas is introduced at 500 sccm and triethylboron is introduced at 800 sccm. Microwaves with frequency 2.45 GHz and power 2.8 kW are introduced from the microwave introducing pipe 401 for decomposing ammonia gas. The film formation is carried out at the sample temperature of 390°C by setting the pressure of the reaction chamber at 1 Torr.

The SiBN film formed under the aforementioned conditions has an excellent step coverage characteristic similar to the first and the second embodiments, with a sufficiently small relative permittivity of 3.6.

It is to be noted that the case of using HMCTSZN as the organic silicon compound has been employed in conjunction with the description of the embodiments of the present invention in the above. However, hexamethyldisilazane $[Si(CH_3)_3]_2NH$ may be used instead.

Moreover, trimethylamine $N(C_2H_5)_3$ may also be used as the organic compound containing nitrogen.

## Claims

1. A method of manufacturing a silicon-boron nitride film, comprising the step of forming a silicon-boron nitride film by a chemical vapor deposition method using a raw material gas having an organosilicon compound, an organoboron compound and a compound containing nitrogen.

2. A method of manufacturing a silicon-boron nitride film as claimed in claim 1, wherein said compound containing nitrogen is ammonia or an organic compound containing nitrogen.

3. A method of manufacturing a silicon-boron nitride film as claimed in claim 2, wherein said organic compound containing nitrogen is triethylamine.

4. A method of manufacturing a silicon-boron nitride film as claimed in claim 1, wherein said organosilicon compound is hexamethylcyclotrisilazane or hexamethyldisilazane.

5. A method of manufacturing a silicon-boron nitride film as claimed in claim 2, wherein said organosilicon compound is hexamethylcyclotrisilazane or hexamethyldisilazane.

6. A method of manufacturing a silicon-boron nitride film as claimed in claim 1, wherein said organoboron compound is trimethylboron or triethylboron.

7. A method of manufacturing a silicon-boron nitride film as claimed in claim 2, wherein said organoboron compound is trimethylboron or triethylboron.

8. A method of manufacturing a silicon-boron nitride film as claimed in claim 2, wherein said chemical vapor deposition method is a plasma chemical vapor deposition method.

9. A method of manufacturing a silicon-boron nitride film as claimed in claim 2, wherein said chemical vapor deposition method is a photo-assisted chemical vapor deposition method.

10. A method of manufacturing a silicon-boron nitride film as claimed in claim 2, wherein said chemical vapor deposition method is a chemical vapor deposition method in which ammonia or an organic compound containing nitrogen is decomposed in advance using an ultraviolet radiation or plasma, which is then mixed with other raw material gases to be used for deposition of a silicon-boron nitride film.

11. A method of manufacturing a semiconductor device comprising the step of:
forming wirings on a semiconductor substrate; and forming a silicon-boron nitride film on said wirings by a chemical vapor deposition method using raw material gases having an organosilicon compound, an organoboron compound and a compound containing nitrogen.

12. A method of manufacturing a semiconductor device as claimed in claim 11, wherein said compound containing nitrogen is ammonia or an organic compound containing nitrogen.

13. A method of manufacturing a semiconductor device as claimed in claim 12, wherein said organic compound containing nitrogen is triethylamine.

14. A method of manufacturing a semiconductor device as claimed in claim 11, wherein said organosilicon compound is hexamethylcyclotrisilazane or hexamethyldisilazane.

15. A method of manufacturing a semiconductor device as claimed in claim 12, wherein said organosilicon compound is hexamethylcyclotrisilazane or hexamethyldisilazane.

16. A method of manufacturing a semiconductor device as claimed in claim 11, wherein said organoboron compound is trimethylboron or triethylboron.

17. A method of manufacturing a semiconductor device as claimed in claim 12, wherein said organoboron compound is trimethylboron or triethylboron.

18. A method of manufacturing a semiconductor device as claimed in claim 12, wherein said chemical vapor deposition method is a plasma chemical vapor deposition method.

19. A method of manufacturing a semiconductor device as claimed in claim 12, wherein said chemical vapor deposition method is a photo-assisted chemical vapor deposition method.

20. A method of manufacturing a semiconductor device as claimed in claim 12, wherein said chemical vapor deposition method is a chemical vapor deposition method in which ammonia or an organic compound containing nitrogen is decomposed in advance using an ultraviolet radiation or plasma, which is then mixed with other raw material gases to be used for deposition of a silicon-boron nitride film.

Fig. 1

Fig. 2 (a)

Fig. 2 (b)

Fig. 3

EP 0 394 054 A1

Fig. 4

EP 0 394 054 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,A | EP-A-0 355 366 (SIEMENS AG) * claims 1,2,9 * | 1,2,8, 11,12, 18 | H 01 L 21/318 C 23 C 16/34 C 23 C 16/44 |
| D,Y | PATENT ABSTRACTS OF JAPAN vol. 11, no. 396 (E-568), 24 December 1987; & JP-A-62156822 (NTT) 11.07.1987 | 1,2,4-8 ,11,12, 14-18 | |
| Y | PATENT ABSTRACTS OF JAPAN vol. 12, no. 405 (C-539)(3252), 26 October 1988; & JP-A-63145777 (KATSUMITSU NAKAMURA) 17.06.1988 | 1,2,4-8 ,11,12, 14-18 | |
| Y | THIN SOLID FILMS vol. 153, no. 1, 26 October 1987, pages 521-529, Lausanne, Switzerland; T.A. BROOKS et al.: "Plasma-Enhanced Chemical Vapor Deposition of Silicon Nitride from 1,1,3,3,5,5-Hexamethylcyclotrisilazane and Ammonia" * pages 521-522; chapter 1 * | 1,2,4-8 ,11,12, 14-18 | |
| A | EP-A-0 030 638 (IBM) * page 4, line 15 - page 5, line 24; page 12, lines 4-22; page 14, line 21 - page 15, line 14; claims 1,3,10 * | 1-20 | TECHNICAL FIELDS SEARCHED (Int. Cl.5) H 01 L C 23 C C 30 B |
| A | 1988 SYMPOSIUM ON VLSI TECHNOLOGY 10-13 May 1988, pages 93,94, San Diego, California, US; M. MAEDA et al.: "Low Permittive Interconnection Using SiBN Interlayer for High Speed Bipolar LSis" * page 93 * | 1,2,8, 11,12, 18 | |

-/-

The present search report has been drawn up for all claims

| Place of search | Date of completion of the search | Examiner |
|---|---|---|
| BERLIN | 28-06-1990 | KLOPFENSTEIN P R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

**European Patent
Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN vol. 12, no. 369 (E-665), 4 October 1988; & JP-A-63120444 (NTT) 24.05.1988 | 1,2,8, 11,12, 18 | |

TECHNICAL FIELDS
SEARCHED (Int. Cl.5)

The present search report has been drawn up for all claims

| Place of search | Date of completion of the search | Examiner |
|---|---|---|
| BERLIN | 28-06-1990 | KLOPFENSTEIN P R |